# EUROPEAN PATENT APPLICATION

(11) **EP 3 587 628 A1**
(43) Date of publication of application: **01.01.2020**
(21) Application number: 18196839.7
(22) Date of filing: 26.09.2018
(51) Int. Cl.: C30B 11/00, C30B 29/42, C30B 31/10, C30B 35/00

(54) **REACTION DEVICE FOR HORIZONTAL BOAT PRODUCTION METHOD**

(30) Priority: 29.06.2018 CN 201810698438
(71) Applicant: Hanergy New Material Technology Co., Ltd., Yanqi Industrial Development Zone Huairou District Beijing 101407 (CN)
(72) Inventor: Lei, Rengui, Beijing, Beijing 101407 (CN); Xiao, Yadong, Beijing, Beijing 101407 (CN); Tan, Xiaotian, Beijing, Beijing 101407 (CN)
(74) Representative: Cohausz & Florack

(57) **Abstract**

The present disclosure provides a reaction device for a horizontal boat production method. The device comprises a closed reaction tube (1), and a horizontal boat container (2, 4, 5), wherein the horizontal boat container (2, 4, 5) include a plurality of first-layer horizontal boat containers (2) and a second-layer horizontal boat container (4) superposed on a bracket device (3) provided on at least one of the first-layer horizontal boat containers (2).

## Description

### TECHNICAL FIELD

The present disclosure relates to the technical field of horizontal boat production methods, and in particular relates to a reaction device for a horizontal boat production method.

### BACKGROUND

The Horizontal Bridgman method is a method for preparing large-area shaped flaky crystals developed by Bridgman, also known as the horizontal boat method, referred to as the HB method. The HB method is widely used, especially in the growth of compound semiconductor crystals, and can also be used for doping of semiconductor materials. The HB method is to place a raw material or doping raw material for growing crystals in a vessel to be placed in a circular tube, and close a nozzle of the tube after vacuumizing; the crystal is grown by directional solidification or directional zone melting, or the semiconductor is doped by a suitable semiconductor doping method.

Jin Min et al. introduce horizontal directional solidification for synthesizing gallium arsenide polycrystals (Journal of Shanghai Institute of Technology, September 2014, 187-190), where a furnace consisting of 8 stages of controlled single crystal temperature includes 5 stages of high temperature zone, 1 stage of medium temperature zone, and 2 stages of low temperature zone. Arsenic and gallium are placed in a quartz boat at two ends of a quartz tube, respectively. The quartz tube is welded in vacuum-sealed manner and then placed in a horizontal directional solidification furnace, where the gallium end is placed in the high temperature zone, and the arsenic end is placed in the low temperature zone. A temperature in the low temperature zone is controlled at around 630 °C, and a temperature in the high temperature zone is controlled at 1250 to 1255 °C. A directional solidification of gallium arsenide polycrystals is achieved by controlling a cooling process of different stages.

CN107268085A discloses a preparation device for doping semi-insulating gallium arsenide polycrystal with carbon, including a cylindrical heating device, wherein one end of the heating device is a source region and the other end is a growth region. A control temperature of the heating device increases from the source region to the growth region. A quartz tube is fixedly disposed in the heating device. A first PBN boat for receiving graphite powder and a second PBN boat for receiving a chloride, fluoride or oxide of Groups III to IV are disposed adjacently at a position in the quartz tube corresponding to the source region, and a third PBN boat for receiving gallium arsenide polycrystals is disposed at a position in the quartz tube corresponding to the growth region. The quartz tube is in a vacuum-sealed state during reaction.

### SUMMARY

An aspect of the present disclosure provides a reaction device for a horizontal boat production method, comprising a closed reaction tube, and a horizontal boat container,
wherein the horizontal boat container includes a plurality of first-layer horizontal boat containers disposed at different positions in the reaction tube in a horizontal direction, at least one of the first-layer horizontal boat containers is provided with a bracket device on which a second-layer horizontal boat container is superposed, wherein the bracket device is configured to support the second-layer horizontal boat container and provides a gap between the first-layer horizontal boat container and the second-layer horizontal boat container.

### BRIEF DESCRIPTION OF DRAWINGS

Fig. 1 is a schematic view of a reaction device according to an embodiment of the disclosure;
Fig. 2 is a schematic view of a reaction device according to an embodiment of the disclosure;
Fig. 3 is a schematic view of a reaction device according to an embodiment of the disclosure;
Fig. 4 is a schematic view of a reaction device according to an embodiment of the disclosure;
Fig. 5 is a schematic view showing a projection of an example of the horizontal boat container used in the disclosure;
Fig. 6 is a schematic view showing a projection of a horizontal boat container used in an embodiment of the disclosure;
Fig. 7 is a schematic view showing a projection of a horizontal boat container used in an embodiment of the disclosure;
Fig. 8 is a cross sectional view showing a horizontal boat container used in an embodiment of the disclosure;
Fig. 9 is a cross sectional view showing a horizontal boat container used in an embodiment of the disclosure;
Fig. 10 is a plan view showing a of a horizontal boat container used in an embodiment of the disclosure;
Fig. 11 is a structural view showing a bracket used in an embodiment of the disclosure; and
Fig. 12 is a structural view showing a bracket used in an embodiment of the disclosure.

### DETAILED DESCRIPTION

Embodiments of the present disclosure are described below in conjunction with the drawings. Similar reference numerals are used throughout the drawings to describe similar or identical components. The various features disclosed herein may be used alone or in combination with one another, and the disclosure is not limited to the specific combinations described herein. The described embodiments are therefore not intended to limit the scope of the claims.

The phrase "in an embodiment", "in embodiments", "in some embodiments", or "in other embodiments" may be employed in the description, each referring to one or more of the same or different embodiments as disclosed herein.

It should also be noted that, in this context, relational terms such as first and second, are used merely to distinguish one entity or operation from another without necessarily requiring or implying that there is any such actual relationship or order between such entities or operations. Moreover, the term "comprise," "comprising" or any variant thereof means to be non-exclusive so that an item or device including a series of elements includes not only said elements, but also other elements not explicitly listed, or inherent elements of such items or devices. In the absence of more limitations, an element defined by "includes a ..." do not exclude the existence of additional identical elements in the item or device including the element.

An object of the present disclosure is to provide a reaction device for a horizontal boat production method. The present disclosure seeks to improve current placement of horizontal boats, so that a reactant can be more flexibly arranged or the number of crystal rods (wafers) obtained in one reaction can be increased. The present disclosure proposes a plurality of technical solutions. The plurality of technical solutions are described in detail below by way of embodiments.

### [Embodiment 1]

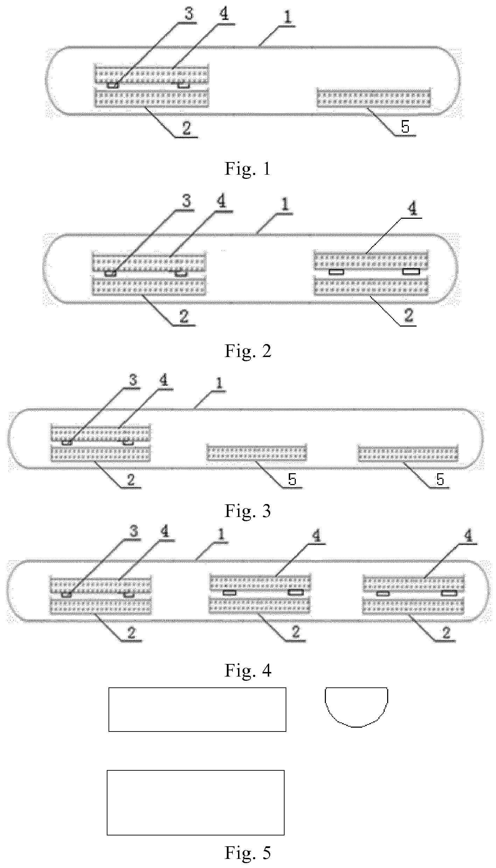

As shown in Fig. 1, a reaction device for a horizontal boat production method (HB method) used in Embodiment 1 includes a closed reaction tube 1 and a horizontal boat container. Three horizontal boat containers are disposed at different positions of the reaction tube 1.

A first-layer horizontal boat container 2 is placed at a left side of the closed reaction tube 1 and provided with a bracket device 3 on which a second-layer horizontal boat container 4 is superposed. The bracket device 3 is configured to support the second-layer horizontal boat container 4, and defines a preset gap between the first-layer horizontal boat container 2 and the second-layer horizontal boat container 4, so that a reactant enters or gets out of the superposed horizontal boats.

Another horizontal boat container 5 is arranged at a right side of the closed reaction tube 1.

In a specific application, it is a typical design that regions of the reaction tube 1 at different levels (horizontal height) provide different settings of temperature, and some of the reactant in the horizontal boat sublimates to react with a reactant in another horizontal boat.

### [Embodiment 2]

Embodiment 2 is similar to Embodiment 1 except that four horizontal boats are provided in Embodiment 2 and divided into two groups each employing a superposed arrangement.

As shown in Fig. 2, in the closed reaction tube 1, two first-layer horizontal boat containers 2 are arranged at two ends of the reaction tube 4 in the horizontal direction, each provided with a bracket device 3 on which a second-layer horizontal boat container 4 is superposed. The bracket device 3 is configured to support the second-layer horizontal boat container 4 and provide a gap between the first-layer horizontal boat container 2 and the second-layer horizontal boat container 4.

### [Embodiment 3]

Similar to Embodiments 1 and 2 and as shown in Fig. 3, in the Embodiment 3, three groups of horizontal boat containers are provided in a horizontal direction of the reaction tube 1. The first group is two superposed horizontal boats, and the first-layer horizontal boat container 2 is provided with a bracket device 3 on which a second-layer horizontal boat container 4 is superposed. The other two groups of horizontal boat containers 5 are disposed at an intermediate position and a right position in the horizontal direction respectively and separately.

### [Embodiment 4]

Embodiment 4 is similar to Embodiments 1, 2 and 3 except that three groups of two-layer superposed horizontal boats are provided. As shown in Fig. 4, in the closed reaction tube 1, three first-layer horizontal boat containers 2 are arranged in the horizontal direction, each provided with a bracket device 3 on which one second-layer horizontal boat container 4 is superposed, wherein the bracket device 3 is configured to support the second-layer horizontal boat container 4 and provide a preset gap between the first-layer horizontal boat container 2 and the second-layer horizontal boat container 4.

Through different arrangements and combinations, those skilled in the art may place more kinds of reaction products in the tube according to the needs and target products, or cooperate with a more reasonable arrangement and heating control manner.

### [Reaction Tube]

The reaction tube used in the embodiments may be a quartz reaction tube having a size generally used in the art, such as an inner diameter of 80 mm. An inner diameter of the horizontal boat container placed therein is adapted to the reaction tube, and may be slightly smaller than the inner diameter of the reaction tube. A depth of the horizontal boat container may be set according to the number of layers placed therein. If two layers are provided, the depth of the horizontal boat container is about 40 mm or less, for example, 20 to 35 mm, specifically 24 mm, 28 mm, 31 mm, 34 mm, or the like.

### [Horizontal Boat]

The HB method is to place a raw material for growing single crystals in a vessel to be placed in a circular tube, and close a nozzle of the tube after vacuumizing. The vessel is generally called a "boat". At present, there are synthesizing boats and pulling boats in view of the use. The synthesizing boat is used for synthesizing polycrystals; while the pulling boat is used for growing single crystals.

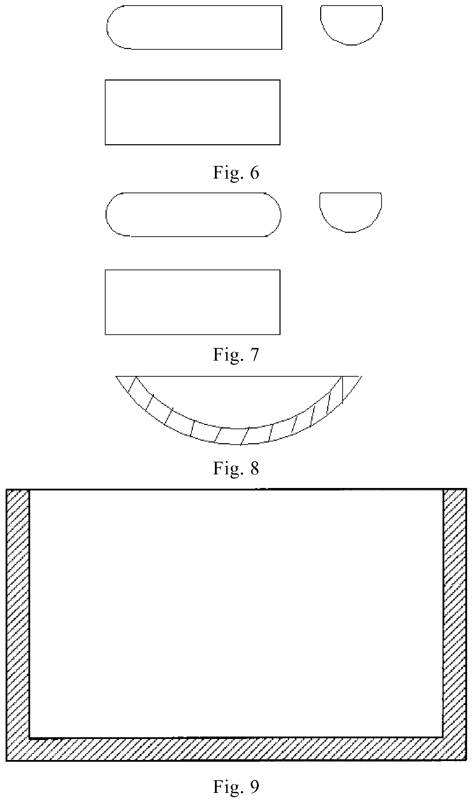

An opening of the synthesizing boat may have a rectangular shape, as shown in the projection view of Fig. 5; or may be semicircle at one end, as shown in the projection view of Fig. 6; or may be semicircle at two ends, as shown in the projection view Fig. 7. Semicircular boats have been used for decades, and their greatest feature is easy to machine: breaking a circular tube in half, and then adding a boat head and/or a boat tail. A main body of the synthesizing boat or the pulling boat typically has an arched cross section, as shown in Fig. 8. Apparently, the cross section may also be rectangular, as shown in Fig. 9, or have other shapes used in the art.

In the projection view, the upper left is a plan view, the lower left is a main view, and the upper right is a left view.

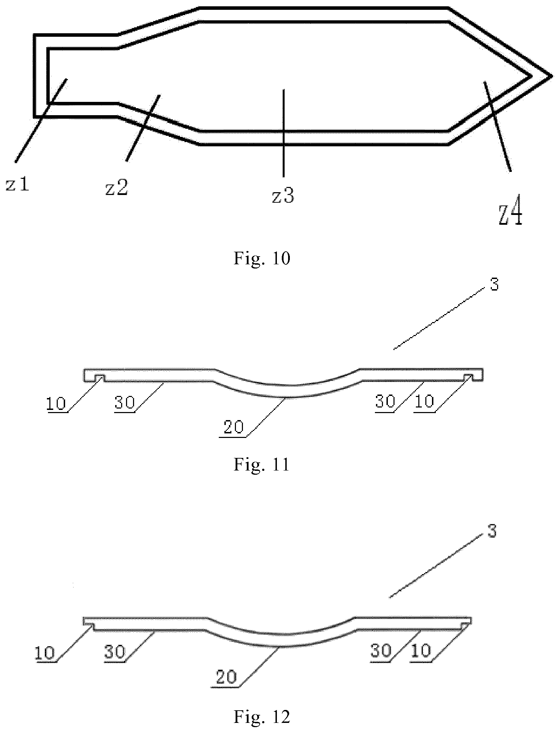

A seed region and a shoulder portion are added into the boat for growing single crystals on the basis of the synthesizing boat for polycrystals. The boat for growing single crystals is composed of: a seed cavity at a front extremity, which has various shapes including square, rectangle and semicircle; a shoulder portion located between a main body and the seed cavity, which has a function of joining the seed cavity and the main body smoothly; the main body portion of the boat for growing single crystals in the middle; and a boat tail at a distal end. Specifically referring to Fig. 10, z1 to z4 show the seed cavity portion, the shoulder portion, an equal diameter portion (i.e., the main body portion) and the boat tail portion in sequence.

### [Bracket Device]

Alternatively, the bracket device 3 may be separately provided. In other words, the bracket device 3 is an independent component from the horizontal boat container. The bracket device 3 may be assembled onto the horizontal boat container to provide support for the horizontal boat container mounted thereon. The bracket device 3 may be mounted to the horizontal boat container after the loading operation is finished. Therefore, the bracket device which is separately provided does not affect the loading operation of the horizontal boat container. Alternatively, the bracket device 3 may be integrated with the horizontal boat container. For example, the bracket device 3 is integrated with an upper portion of the first-layer horizontal boat 2 or a lower portion of the second-layer horizontal boat 4. The integrated arrangement is more convenient to use, and thus is beneficial to realizing industrial production while facilitating structural stability during operation.

Alternatively, the horizontal boat container includes a main body portion disposed substantially at a central portion of the horizontal boat container, the main body portion having a generally U-shaped cross section.

Alternatively, the bracket device 3 is provided as a bridge member, two ends of which are respectively snapped on two sidewalls of the horizontal boat container (for example, the first-layer horizontal boat 2) that are arranged substantially in parallel with an axial direction of the reaction tube 1. With the connection by snapping, it allows easy assembly of the horizontal boat container and bracket device, simplifying assembly steps.

Alternatively, a central portion of the bracket device 3 is provided with a concave arched portion 20 to conform to a shape of a bottom of the second-layer horizontal boat container 4. Specifically, a structural schematic view of the bracket is as shown in Fig. 11. In a plane perpendicular to the axial direction of the reaction tube 1, the central portion of the bracket device 3 is provided with the concave arched portion 20. The arched portion 20 of the bracket device 3 abuts the bottom of the horizontal boat container to provide a stable support for the horizontal boat container.

Alternatively, as shown in Figs. 11 and 12, the bracket device 3 further includes a horizontal portion 30 having a thickness of 2 to 3 mm. The arched portion 20 has a thickness of 2.5 to 3.5 mm, which is slightly greater than the thickness of the horizontal portion. For example, the thickness of the arched portion 20 is 0.2 to 0.5 mm greater than the thickness of the horizontal portion 30. Such arrangement is more conducive to stably supporting a boat placed on the upper layer, making the bracket device more durable and facilitating a sufficient and smooth reaction.

Alternatively, an arc length of the arched portion 20 is 1/4 to 1/2, preferably 1/3, of a perimeter of an outer surface of a horizontal boat container placed on the bracket.

Alternatively, the bracket device 3 further includes two recesses 10 for snapping the bracket 3 onto the horizontal boat container 2. The recesses 10 may be disposed at a position of the horizontal portion 30 adjacent to an end thereof, as shown in Figs. 11 and 12. By the arrangement of the recesses, the bracket device 3 may be stably engaged with a lower-layer horizontal boat container (for example, the first-layer horizontal boat container 2) to form a stable assembly.

In order to make an upper-layer horizontal container supported by the bracket more stable, alternatively, a depth of the recess 10 is 1 to 1.5 mm, more advantageously 1.2 to 1.4 mm, most advantageously about 1.3 mm, thus making the snap more stable. The two recesses may have the same depth.

Width and thickness of the bracket 3 and sizes related to the recess 10 applied in the disclosure may be adjusted according to actual needs. A size of the recess 10 may be set according to a wall thickness of the horizontal boat container as long as it is just snapped with or slightly larger than the wall thickness.

A length of the bracket in the disclosure may be set according to a width of the lower-layer horizontal boat container spanned by the bracket, and is considered to facilitate better movement of the superposed boat inside the quartz tube. One specific form of the bracket is a bridge bracket.

Alternatively, the number of the bracket devices 3 disposed on one horizontal boat is 1, 2, 3, 4, and the like, and preferably 2 or more, especially 3.

Alternatively, the reaction device of the embodiments is used for semiconductor synthesis or semiconductor doping reactions.

Alternatively, the reaction device is used for synthesizing gallium arsenide polycrystals or single crystals, optionally for synthesizing gallium arsenide polycrystals.

Alternatively, the bracket device is made of a PBN (pyrolysis boron nitride) material or a graphite material with depositing a layer of PBN (pyrolysis boron nitride) material on a surface of the graphite material. It needs to be considered not to introduce impurities during the reaction when selecting the material of the bracket device.

An embodiment of the present disclosure further provides a synthesizing device for gallium arsenide polycrystals, including the reaction device for a horizontal boat production method (HB method) of the disclosure.

The synthesizing device of the disclosure may be used in a synthesizing method for a horizontal boat production method. During reaction, the closed reaction tube is vacuumized or filled with an inert gas for protection.

Alternatively, in two adjacent layers, a loading weight of an upper-layer horizontal boat container is less than a loading weight of a lower-layer horizontal boat container, preferably that the loading weight of the lower-layer horizontal boat container is 1 to 1.5 times, more advantageously about 1.3 times, the loading weight of the upper-layer horizontal boat container.

To improve understanding of the technical solution of the present disclosure for those skilled in the art, growth of gallium arsenide polycrystals and doped gallium arsenide polycrystals with carbon are taken as examples for illustration.

### [Embodiment 5] Growth of gallium arsenide polycrystals

As shown in Fig. 1, the synthesizing device for gallium arsenide polycrystals of this embodiment includes a closed quartz reaction tube 1, where two first-layer PBN horizontal boat containers 2 are arranged at two ends of the reaction tube 1 in the horizontal direction. One of the first-layer PBN horizontal boat containers 2 is provided with a bridge member 3 as shown in Fig. 11, and a second-layer PBN horizontal boat container 4 is superposed on the bracket device 3, wherein two ends of the bridge member are respectively snapped on two sidewalls of the first-layer PBN horizontal boat that are arranged substantially in parallel with an axial direction of the reaction tube.

A horizontal portion of the bridge member has a thickness of 2.5 mm, an arched portion has a thickness of 3.0 mm, and an arc length of the arched portion is about 1/3 of a perimeter of an outer surface of a horizontal boat container placed on the bracket. The bracket further includes two recesses each having a depth of 1.3 mm.

The method for growing gallium arsenide polycrystals includes the steps of:
(1) cleaning and drying materials including a quartz reaction tube, a PBN boat and a PBN bridge, and cooling the PBN boat after baking for further use;
(2) weighing about 2000g of 6N gallium, placing it in a PBN boat and then at an end of an opening of the quartz reaction tube, and evenly placing 3 PBN bridges on the boat, and weighing about 1500g of 6N gallium, placing it in another PBN boat and then on the boat with the PBN bridges, and pushing them together onto a bottom of the quartz reaction tube at the same time; weighing about 3680g of 6N arsenic, placing it in a PBN boat and placing the boat into a cleaned port of the quartz reaction boat and finally covering with a quartz cap;
(3) transferring the installed quartz reaction tube onto a furnace, vacuumizing and heating to a temperature of 150 to 300°C, turning off the power after 3 to 4 hours of heat preservation, welding in a vacuum-sealed manner and naturally cooling to room temperature;
(4) installing the sealed quartz reaction tube with arsenic and gallium into an HB horizontal furnace body, placing an end of the boat with arsenic in a low temperature zone and an end of the boat with gallium in a high temperature zone;
(5) heating with a temperature in the low temperature zone controlled at about 620 to 650°C (arsenic sublimation point being 613°C) and a temperature of the high temperature zone furnace at 1250 to 1255°C (higher than melting point of gallium arsenide, 1238°C), preserving the temperatures for 1 to 3hours, the arsenic from the low temperature end sublimating to chemically react with the gallium in the high temperature zone until the arsenic is completely evaporated, and cooling to room temperature to obtain gallium arsenide polycrystals after sufficient reaction;
(6) taking the quartz reaction tube out of the furnace body, cutting the quartz tube from the arsenic end, and taking out and testing the synthesized semicircular polycrystalline rod.

A polycrystalline rod obtained by three times of synthesis has a glossy, dense, non-porous, non-gallium-rich surface with a good synthesis ratio; one polycrystalline rod is taken from each furnace to take a piece of head portion or tail portion for testing. The polycrystal obtained by three times of synthesis has a yield greater than 93%, and carrier concentrations at the head and the tail in the same crystal rod do not have great differences, thus it can be seen that the obtained crystal has a good uniformity in radial direction.

### [Embodiment 6] Gallium arsenide polycrystals doped with carbon

Referring to Fig. 2, a preparation device for doping semi-insulating gallium arsenide polycrystal with carbon of the embodiment is shown. The device includes a closed quartz reaction tube 1, two first-layer PBN horizontal boat containers 2 arranged at two ends of the reaction tube 1 in the horizontal direction. Each of the first-layer PBN horizontal boat containers 2 is provided with a bridge member 3 as shown in Fig. 12, and a second-layer PBN horizontal boat container 4 is superposed on the bracket device 3, wherein two ends of the bridge member are respectively snapped on two sidewalls of the first-layer PBN horizontal boat that are arranged substantially in parallel with an axial direction of the reaction tube.

A horizontal portion of the bridge member has a thickness of 2.5 mm, an arched portion has a thickness of 3.0 mm, and an arc length of the arched portion is about 1/3 of a perimeter of an outer surface of a horizontal boat container placed on the bracket. The bracket further includes two recesses each having a depth of 1.3 mm. The quartz reaction tube 1 is in a vacuum-sealed state during the reaction.

The method for preparing doped gallium arsenide polycrystals with carbon includes the steps of:
(1) cleaning and drying materials including a quartz reaction tube, a PBN boat and a PBN bridge, and cooling the PBN boat after baking for further use;
(2) placing 5 g of a Group III-IV chloride such as gallium chloride in a PBN boat and then placing it at an end of an opening of the quartz reaction tube, and evenly placing 3 PBN bridges on the boat, placing 2 g of graphite powder in another PBN boat and then on the boat with the PBN bridges, and pushing them together onto a bottom of the quartz reaction tube at the same time; placing 3 kg of gallium arsenide polycrystals in a PBN boat, superposing another PBN boat containing 3 kg of gallium arsenide polycrystals thereon according to the above steps, placing the boat into a cleaned port of the quartz reaction boat at the same time and finally covering with a quartz cap; an amount of the graphite powder is less than an amount of the chloride;
(3) vacuumizing the installed quartz reaction tube, welding the quartz reaction tube with a hydrogen-oxygen flame for sealing treatment;
(4) turning on the heating device, the graphite powder and the chloride chemically reacting to form a gas phase substance of a carbon compound, which is doped into the gallium arsenide polycrystals by physical vapor phase transfer under an action of temperature gradient;
(5) placing the doped gallium arsenide polycrystals in a quartz container for polycrystalline synthesis at 1000 °C to 1300 °C so that the chlorine or fluorine element therein is volatilized and the carbon (C) concentration therein is evenly distributed, thus obtaining a product of doped semi-insulating gallium arsenide polycrystals with carbon.

After testing, the two doped semi-insulating gallium arsenide polycrystals with carbon prepared in the present embodiment, and the semi-insulating gallium arsenide single crystals obtained by drawing both have a resistivity up to about 10⁸ Ω·cm; a uniform C concentration of 2×10¹⁵cm⁻³; and a electron mobility of about 5000cm/v.s. As can be seen, the doped semi-insulating gallium arsenide single crystals with carbon obtained at the same have good and similar performance.

By placing superposed horizontal boat containers in the reaction tube as shown in the present disclosure, a plurality of target products may be synthesized at the same time, which greatly improves the production efficiency. Meanwhile, the target products obtained by the synthesis have good and consistent performance, and can fully satisfy requirements for further applications. The device of the present disclosure is of great significance for mass production in the field of semiconductors.

### [Variations]

The horizontal boat containers of the present disclosure are not limited to being provided in two layers, and may be provided in more layers such as three layers, four layers, or the like by adjusting a thickness of the horizontal boat container. In addition, the horizontal boat containers are not limited to being divided into two groups, and may be more than two groups, such as three groups, four groups, or the like, and may be used for, for example, InGaAsP quaternary compounds or multi-component doping.

### [Advantageous effects]

At present, the horizontal boat containers are generally arranged at different positions of the closed reaction tube in the horizontal direction. Considering that the reaction tube is circular, an interior of the horizontal boat container is hollow and semi circular, and the two semicircular boats are difficult to be superposed, which tends to cause structural instability, and due to limited space inside the reaction tube, the arrangement of the horizontal boat containers is further limited.

The present disclosure proposes a bracket device that greatly facilitates placement of the upper-layer boat. Based on this, the present disclosure proposes a synthesizing device where the horizontal boat containers are superposed, which is particularly suitable for improving the HB method. The superposed configuration of the plurality of horizontal boat containers of the present disclosure is stable, enables a reaction to be performed smoothly and normally, improves the production efficiency, and saves cost. A plurality of crystal rods are allowed to be prepared at a time without increasing the volume of the reaction tube.

In addition, the reaction device provided by the present disclosure may further improve semiconductor synthesis and semiconductor doping processes. The present disclosure provides a design for superposing horizontal boat containers in a closed reaction tube, and in particular provides a unique design for providing a first-layer horizontal boat container with a bracket device on which a second-layer horizontal boat container is superposed. Compared to traditional designs, it is conducive to the development of new semiconductor preparation processes, new semiconductor synthesis methods, and new semiconductor products.

The present disclosure includes at least the following concepts:
Concept 1. A reaction device for horizontal boat production method, comprising: a closed reaction tube provided with horizontal boat containers at different position of the reaction tube in a horizontal direction,
   wherein the horizontal boat containers include a plurality of first-layer horizontal boat containers, and a second-layer superposed on a bracket device provided on at least one of the first-layer horizontal boat containers, wherein the bracket device is configured to support the second-layer horizontal boat container and provides a gap between the first-layer horizontal boat container and the second-layer horizontal boat container.
Concept 2. The reaction device according to Concept 1, wherein the bracket device is separately provided.
Concept 3. The reaction device according to Concept 1, wherein the bracket device is integrated with the horizontal boat container.
Concept 4. The reaction device according to Concept 3, wherein the bracket device is integrated with an upper portion of the first-layer horizontal boat container or a lower portion of the second-layer horizontal boat container.
Concept 5. The reaction device according to any one of Concepts 1 to 4, wherein the horizontal boat container includes a main body portion disposed substantially at a central portion of the horizontal boat container, the main body portion having a generally U-shaped cross section.
Concept 6. The reaction device according to any one of Concepts 1 to 5, wherein the bracket device is a bridge member, two ends of which are respectively snapped on two sidewalls of the first-layer horizontal boat that are arranged substantially in parallel with an axial direction of the reaction tube.
Concept 7. The reaction device according to Concept 6, wherein a central portion of the bracket device is provided with a concave arched portion to conform to a shape of a bottom of the second horizontal boat container.
Concept 8. The reaction device according to Concept 7, wherein the bracket device further comprises a horizontal portion with a thickness of 2 to 3 mm, and the arched portion has a thickness of 2.5 to 3.5 mm, which is slightly greater than the thickness of the horizontal portion.
Concept 9. The reaction device according to Concept 8, wherein the arched portion has a thickness 0.2 to 0.5 greater than the thickness of the horizontal portion.
Concept 10. The reaction device according to Concept 7, wherein an arc length of the arched portion is 1/4 to 1/2, preferably 1/3, of a perimeter of an outer surface of a horizontal boat container placed on the bracket.
Concept 11. The reaction device according to any one of Concepts 1 to 10, wherein the bracket further includes two recesses for snapping the bracket onto the horizontal boat container.
Concept 12. The reaction device according to Concept 11, wherein each of the recesses has a depth of 1 to 1.5 mm, and the two recesses have the same depth.
Concept 13. The reaction device according to any one of Concepts 1 to 12, wherein the number of the bracket devices is two or more.
Concept 14. The reaction device according to any one of Concepts 1 to 13, wherein the bracket device is made of a PBN material or a graphite material with depositing a layer of PBN material on a surface of the graphite material.
Concept 15. The reaction device according to any one of Concepts 1 to 14, wherein the reaction device is used for semiconductor synthesis or semiconductor doping.
Concept 16. The reaction device according to Concept 15, wherein the reaction device is used for gallium arsenide polycrystalline synthesis or gallium arsenide single crystal synthesis.
Concept 17. A synthesizing device for gallium arsenide poly crystals, comprising the reaction device for horizontal boat production method according to any one Concepts 1 to 14.

## Claims

1. A reaction device for horizontal boat production method, comprising: a closed reaction tube (1), and a horizontal boat container (2, 4, 5),
wherein the horizontal boat container (2, 4, 5) includes a plurality of first-layer horizontal boat containers (2) disposed at different positions in the reaction tube (1) in a horizontal direction, at least one of the first-layer horizontal boat containers (2) is provided with a bracket device (3) on which a second-layer horizontal boat container (4) is superposed, wherein the bracket device (3) is configured to support the second-layer horizontal boat container (4) and provides a gap between the first-layer horizontal boat container (2) and the second-layer horizontal boat container (4).

2. The reaction device according to claim 1, wherein the bracket device (3) is separately provided.

3. The reaction device according to claim 1, wherein the bracket device (3) is integrated with the horizontal boat container (2, 4, 5).

4. The reaction device according to claim 3, wherein the bracket device (3) is integrated with an upper portion of the first-layer horizontal boat container (2) or a lower portion of the second-layer horizontal boat container (4).

5. The reaction device according to any one of claims 1 to 4, wherein the horizontal boat container (2, 4, 5) includes a main body portion disposed substantially at a central portion of the horizontal boat container (2, 4, 5), the main body portion having a generally U-shaped cross section.

6. The reaction device according to any one of claims 1 to 5, wherein the bracket device (3) is a bridge member, two ends of the bridge member are respectively snapped on two sidewalls of the horizontal boat container (2, 4, 5) that are arranged substantially in parallel with an axial direction of the reaction tube (1).

7. The reaction device according to claim 6, wherein a central portion of the bracket device (3) is provided with a concave arched portion (20) to conform to a shape of a bottom of the second horizontal boat container (4).

8. The reaction device according to claim 7, wherein an arc length of the arched portion (20) is 1/4 to 1/2, preferably 1/3, of a perimeter of an outer surface of the horizontal boat container (2, 4, 5) placed on the bracket (3).

9. The reaction device according to any one of claims 1 to 8, wherein the bracket further includes two recesses (10) for snapping the bracket (3) onto the horizontal boat container (2, 4, 5).

10. The reaction device according to any one of claims 1 to 9, wherein the number of the bracket devices (3) is two or more.

11. The reaction device according to any one of claims 1 to 10, wherein the bracket device (3) is made of a PBN material or a graphite material with depositing a layer of PBN material on a surface of the graphite material.

12. The reaction device according to any one of claims 1 to 11, wherein the reaction device is used for semiconductor synthesis or semiconductor doping.

13. The reaction device according to claim 12, wherein the reaction device is used for gallium arsenide polycrystalline synthesis or gallium arsenide single crystal synthesis.
